# EUROPÄISCHE PATENTSCHRIFT

(11) **EP 3 474 434 B1**
(45) Veröffentlichungstag und Bekanntmachung des Hinweises auf die Patenterteilung: **29.12.2021**
(21) Anmeldenummer: 18177926.5
(22) Anmeldetag: 15.06.2018
(51) Int. Cl.: H02M 7/48, B60L 15/00

(54) **ELEKTRISCHES ANTRIEBSSYSTEM**
ELECTRICAL PROPULSION SYSTEM
SYSTÈME DE PROPULSION ÉLECTRIQUE

(30) Priorität: 23.10.2017 DE 102017218866
(43) Veröffentlichungstag der Anmeldung: 24.04.2019
(73) Patentinhaber: AUDI AG, 85045 Ingolstadt (DE)
(72) Erfinder: Apelsmeier, Andreas, 85131 Pollenfeld (DE); Schiedermeier, Maximilian, 85049 Ingolstadt (DE)

(56) Entgegenhaltungen:
- EP-A2- 2 456 065
- WO-A1-2016/014901
- WO-A1-2017/186390
- DE-A1-102010 014 971
- DE-T5-112014 006 826
- US-A1- 2017 213 811
- OZDEMIR SADIK ET AL: "Comparison of silicon carbide MOSFET and IGBT based electric vehicle traction inverters", 2015 INTERNATIONAL CONFERENCE ON ELECTRICAL ENGINEERING AND INFORMATICS (ICEEI), IEEE, 10 August 2015 (2015-08-10), pages 1-4, XP032851051, DOI: 10.1109/ICEEI.2015.7387215 ISBN: 978-1-4673-6778-3 [retrieved on 2016-01-19]

## Beschreibung

Die vorliegende Erfindung bezieht sich auf ein mehrere Antriebe umfassendes elektrisches Antriebssystem für Kraftfahrzeuge, insbesondere für reine Elektrofahrzeuge, und ein Verfahren zum Betreiben des Antriebssystems.

In rein elektrisch angetriebenen Kraftfahrzeugen, wie batterieelektrischen Fahrzeugen (BEV) oder Brennstoffzellenfahrzeugen, sind häufig mehrere Antriebe auf unterschiedlichen Achsen verbaut. In jedem der Antriebe wird die gleiche Leistungselektronik mit Si-Leistungshalbleitern verwendet.

Aktuelle Fahrzeuge weisen noch eine vergleichsweise geringe Reichweite auf und die Kosten für die HV-Batterie sind hoch. Daher hat sich die vorliegende Erfindung die Aufgabe gestellt, ein Antriebssystem zur Verfügung zu stellen, welches eine vorgegebene Reichweite ohne Leistungseinbußen mit geringerer Batteriekapazität erreichen kann.

Die Aufgabe wird erfindungsgemäß gelöst durch eine Vorrichtung mit den Merkmalen des Anspruchs 1 und ein Verfahren mit den Merkmalen des Anspruchs 9. Ausgestaltungen der Vorrichtung und des Verfahrens ergeben sich aus den abhängigen Ansprüchen.

Der Wirkungsgrad von leistungselektronischen Komponenten kann entscheidend erhöht werden, wenn anstelle von Halbleiterbauteilen auf Siliziumbasis solche auf Basis von Siliziumkarbid (SiC) eingesetzt werden.

Die US 2015/246614 A1 offenbart ein in einer Fahrbahn eingebautes induktives Energietransfersystem. In der die Induktionsspulen versorgenden Einheit können Siliziumkarbid-Halbleiterbauteile eingesetzt werden, um die durch die Induktionsspulen fließenden Ströme zu schalten.

Aus der DE 10 2016 207 254 A1 sind ein Wechselrichter zum Bereitstellen von Phasenströmen für eine elektrische Maschine sowie eine elektrische Antriebsanordnung für ein Hybridelektro-/Elektrofahrzeug mit einem solchen Wechselrichter bekannt. Der Wechselrichter umfasst einen als Siliziumkarbid-Halbleiterschalter ausgeführten Durchleitungsschalter, welcher beim Wegfall des Steuersignals automatisch geschlossen wird. Der Durchleitungsschalter kann ein MOSFET oder IGBT sein.

Aus der WO 2016/002057 A1 geht ein Siliziumkarbid-Halbleiterbauteil hervor, welches in einem Leistungsmodul, einem Wechselrichter und einem Dreiphasen-Motor-System für ein Elektrofahrzeug eingesetzt werden kann.

Aus der WO 2017/186390 A1 ist ein elektrisches System mit mindestens zwei Modulen bekannt, wobei ein Modul mindestens ein Schaltelement umfasst. Das erste Modul umfasst ein erstes Schaltelement aus Silizium und das zweite Modul umfasst ein zweites Schaltelement aus Siliziumcarbid.

Die DE 10 2010 014 971 A1 offenbart ein Verfahren zum Betreiben eines Kraftfahrzeugs mit zumindest zwei Antrieben, bei dem eine Eingabe eines Fahrzeugführers empfangen wird und aufgrund selbiger durch eine erste Steuereinrichtung, welche Erstmesswerte zu Erstgrößen empfängt, ein Gesamtdrehmoment ermittelt wird, wobei die erste Steuereinrichtung zunächst eine Schar von Kombinationen jeweiliger Teildrehmomente für einzelne Antriebseinheiten vorgibt und hierzu Datensignale (Tₘᵢₙ, Tₘₐₓ, T_{W}) an eine zweite Steuereinrichtung sendet, die Zweitmesswerte empfängt zu von den Erstgrößen verschiedenen Zweitgrößen. Die zweite Steuereinrichtung nimmt eine Auswahl aus der Schar vor und sendet hierzu Datensignale (T'ₘᵢₙ , T'ₘₐₓ und T'_{W}) an die erste Steuereinrichtung, welche daraufhin das Gesamtdrehmoment in Teildrehmomente für die einzelnen Antriebseinheiten aufteilt und Steuerbefehle an selbige sendet, um die jeweiligen Teildrehmomente von ihnen anzufordern.

Ozdemir Sadik et al.: "Comparison of silicon carbide MOSFET and IGBT based electric vehicle traction inverters", 2015 International Conference on Electrical Engineering and Informatics (ICEEI), IEEE, 10. August 2015, S.1-4 vergleicht die Effizienz und die Betriebskosten von Traktionsinvertern mit MOSFET und IGBT Schaltern auf Siliziumkarbidbasis.

Durch einen Traktionsinverter auf SiC-Basis (SiC-Inverter) kann bei einem Fahrzeug mit einem Antrieb im WLTP-Zyklus (Worldwide Harmonized Light-Duty Vehicles Test Procedure) oder NEFZ-Zyklus (Neuer Europäischer Fahrzyklus gemäß Richtlinie 70/220/EWG) eine Einsparung von bis zu etwa 0,5 kWh/100 km erreicht werden. Bei einer Reichweite des Fahrzeugs von 500 km ermöglicht das eine Verringerung von ca. 2,5 kWh Batteriekapazität.

Im normalen Fahrbetrieb eines Fahrzeugs mit zwei elektrischen Antrieben wird hauptsächlich ein Antrieb belastet und der andere wird lediglich mitgeschleppt. Nur bei einer Momentanforderung, welche der erste Antrieb nicht allein erfüllen kann, wird der zweite Antrieb hinzugeschaltet. Die Drehmomentverteilung zwischen den Antrieben wird aus Effizienzgründen hauptsächlich auf einen Antrieb verlagert.

Erfindungsgemäß werden in einem Antriebssystem mit mehreren elektrischen Antrieben mindestens ein Inverter mit Siliziumkarbid-Halbleiterbauteilen (SiC-Inverter) und mindestens ein Inverter mit Silizium-Halbleiterbauteilen (herkömmlicher Si-Inverter) kombiniert. Diese Kombination bietet eine Reihe von Vorteilen. Der niedrige Lastbereich im Fahrbetrieb wird über den hocheffizienten SiC-Inverter abgedeckt. Dadurch verringert sich die zum Erreichen der Reichweitenanforderung benötigte Batteriekapazität. Es kann im Fahrzeug eine Batterie geringerer Kapazität eingesetzt werden, was zu Einsparungen führt. Die geringere Batteriekapazität ermöglicht zudem eine prozentuale Verringerung der Ladezeit. Die Gesamtleistung des Antriebssystems bleibt gleich, da der SiC-Inverter durch den Si-Inverter ergänzt wird. Das Kraftfahrzeug zeigt die gleiche Performance wie ein Fahrzeug mit zwei Si-Invertern.

Gegenstand der Erfindung ist ein elektrisches Antriebssystem für ein Kraftfahrzeug, welches mindestens zwei elektrische Maschinen sowie mindestens einen Inverter mit Silizium-Halbleiterbauteilen und mindestens einen Inverter mit Siliziumkarbid-Halbleiterbauteilen aufweist. Erfindungsgemäß wird mindestens eine elektrische Maschine der mindestens zwei elektrischen Maschinen von dem mindestens einen Si-Inverter versorgt und ist für das Antreiben einer Vorderachse des Kraftfahrzeugs eingerichtet, und mindestens eine elektrische Maschine der mindestens zwei elektrischen Maschinen wird von dem mindestens einen SiC-Inverter versorgt und ist für das Antreiben einer Hinterachse des Kraftfahrzeugs eingerichtet, wobei im Fahrbetrieb des Kraftfahrzeugs ausschließlich über SiC-Inverter mit Wechselstrom versorgte elektrische Maschinen zum Antreiben einer Hinterachse des Kraftfahrzeugs genutzt werden, wenn eine Momentanforderung kleiner ist als ein maximal von den über SiC-Inverter versorgten elektrischen Maschinen erzeugbares Drehmoment; und sowohl über SiC-Inverter mit Wechselstrom versorgte elektrische Maschinen zum Antreiben einer Hinterachse des Kraftfahrzeugs als auch über Si-Inverter mit Wechselstrom versorgte elektrische Maschinen zum Antreiben einer Vorderachse des Kraftfahrzeugs genutzt werden, wenn die Momentanforderung größer ist als das maximal von den über SiC-Inverter mit Wechselstrom versorgten elektrischen Maschinen erzeugbare Drehmoment.

Das erfindungsgemäße elektrische Antriebssystem für ein Kraftfahrzeug, weist mindestens zwei elektrische Maschinen (E-Maschinen) auf. In einer Ausführungsform weist es drei E-Maschinen auf. In einer Ausführungsform weist es vier E-Maschinen auf. In einer Ausführungsform treibt eine E-Maschine eine Vorderachse des Kraftfahrzeugs an und eine andere E-Maschine treibt eine Hinterachse des Kraftfahrzeugs an. In einer anderen Ausführungsform wird jedes Rad des Kraftfahrzeugs von einer eigenen E-Maschine angetrieben.

Jede der E-Maschinen wird über einen ihr zugeordneten separaten Inverter (Wechselrichter) mit Wechselstrom versorgt. Das Antriebssystem weist mindestens einen Inverter mit Silizium-Halbleiterbauteilen und mindestens einen Inverter mit Siliziumkarbid-Halbleiterbauteilen auf. In einer Ausführungsform weist das Antriebssystem zwei E-Maschinen, einen Inverter mit Silizium-Halbleiterbauteilen und einen Inverter mit Siliziumkarbid-Halbleiterbauteilen auf. In einer anderen Ausführungsform weist das Antriebssystem vier E-Maschinen, zwei Inverter mit Silizium-Halbleiterbauteilen und zwei Inverter mit Siliziumkarbid-Halbleiterbauteilen auf.

Der Aufbau von Invertern (Wechselrichtern) ist dem Fachmann im Prinzip bekannt. Ein Inverter erzeugt aus der von einer HV-Batterie oder Brennstoffzelle bereitgestellten Gleichspannung eine Wechselspannung zum Betrieb einer E-Maschine. In einer Ausführungsform des erfindungsgemäßen Antriebssystems sind die Inverter Sinuswechselrichter, d.h. sie erzeugen eine sinusförmige Wechselspannung. In einer Ausführungsform erzeugen die Inverter im Zerhackerbetrieb (Chopper-Betrieb) durch Pulsweitenmodulation (PWM) eine sinusförmige Ausgangs-Wechselspannung. Mit den als Schaltelemente verwendeten Transistoren (z.B. IGBT oder MOSFET) wird durch Pulsweitenmodulation (PWM) im Chopperbetrieb eine Sinus-Wechselspannung aus kurzen Pulsen hoher Frequenz nachgebildet. Die Transistoren polen die Gleichspannung periodisch mit hoher Frequenz um. In einer Ausführungsform liegt die Schaltfrequenz der Inverter in einem Bereich von 10 bis 25 kHz. Der Mittelwert der hochfrequenten, pulsweitenmodulierten Schaltfrequenz ist die Ausgangs-Wechselspannung. Man setzt die Ausgangs-Wechselspannung aus kleinen, unterschiedlich breiten Impulsen zusammen und nähert so den sinusförmigen Spannungsverlauf an.

In einer Ausführungsform umfasst der mindestens eine Inverter mit Silizium-Halbleiterbauteilen (Si-Inverter) mindestens einen Si-IGBT und mindestens eine Si-Diode, d.h. IGBT und Diode sind aus Silizium-Halbleitern gefertigt. In einer Ausführungsform umfasst der mindestens eine Inverter mit Siliziumkarbid-Halbleiterbauteilen (SiC-Inverter) mindestens einen SiC-MOSFET, d.h. einen aus Siliziumkarbid-Halbleitern gefertigten MOSFET. In einer weiteren Ausführungsform umfasst der SiC-Inverter mindestens einen Si-IGBT und mindestens eine SiC Diode.

Gegenstand der Erfindung ist auch ein Verfahren zum Betreiben des erfindungsgemäßen Antriebssystems. Dabei werden im Fahrbetrieb des Kraftfahrzeugs ausschließlich die über SiC-Inverter versorgten E-Maschinen zum Antreiben einer Hinterachse des Kraftfahrzeugs genutzt, wenn die Momentanforderung kleiner ist als das maximal von den über SiC-Inverter versorgten E-Maschinen erzeugbare Drehmoment. Ist die Momentanforderung größer als das maximal von den über SiC-Inverter versorgten E-Maschinen erzeugbare Drehmoment, werden sowohl die von einem SiC-Inverter versorgten E-Maschinen als auch die über einen Si-Inverter versorgten E-Maschinen zum Antreiben einer Vorderachse des Kraftfahrzeugs genutzt. In einer Ausführungsform des Verfahrens wird die Vorderachse des Kraftfahrzeugs über mindestens eine von einem Si-Inverter versorgte E-Maschine angetrieben und die Hinterachse des Kraftfahrzeugs wird über mindestens eine von einem SiC-Inverter versorgte E-Maschine angetrieben.

Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung ist anhand von Ausführungsformen in den Zeichnungen schematisch dargestellt und wird unter Bezugnahme auf die Zeichnungen weiter beschrieben. Es zeigt:
- Figur 1: einen Vergleich der Verlustleistung verschiedener Inverter;
- Figur 2: eine schematische Darstellung einer Ausführungsform eines erfindungsgemäßen Antriebssystems mit zwei unterschiedlichen Invertern.

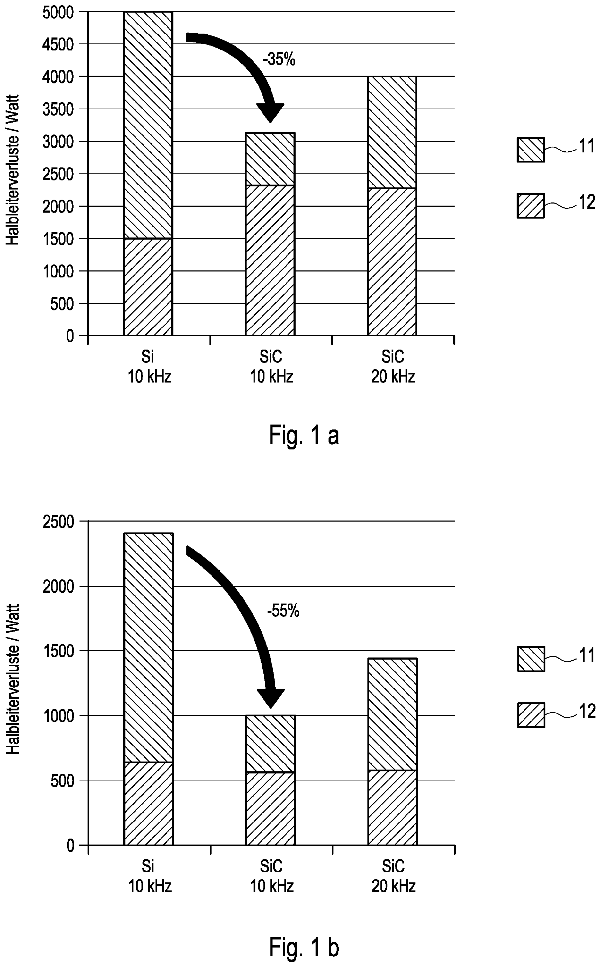

Figur 1 zeigt einen Vergleich der Verlustleistung verschiedener Inverter in einem konstantem Lastpunkt bei unterschiedlichen Taktfrequenzen: a) Vollastbetrieb, b) Teillastbetrieb). Die verwendeten Inverter wurden betrieben mit einer maximalen Leistung von 180 kW, einer maximalen Spannung von 1200 V HL, einem über 10 s gemittelten Wechselstrom von 350 Arms. Die Inverter waren ausgelegt für eine Maximaltemperatur am Übergang (junction) von 175°C (Si-Inverter) bzw. 200°C (SiC-Inverter). Die Verlustdaten wurden aus Messungen bestimmt. Die Randbedingungen für die Berechnung waren cos Phi: 0,7; maximaler Modulationsgrad: 0,9; Wirkungsgrad E-Maschine + Getriebe: 0,9*0,94; DC-Spannung: 800V.

Wie aus Figur 1a ersichtlich, ist die Verlustleistung eines SiC-Inverters bei Vollastbetrieb (350 Arms, Schaltfrequenz 10 kHz) um 35% geringer als die eines Si-Inverters. Die Verlustleistung ist als Summe der Schaltverluste 11 und der Durchlassverluste 12 dargestellt. Die Verringerung geht auf die wesentlich kleineren Schaltverluste 11 zurück. Im Teillastbetrieb (Fig. 1b) mit 175 Arms ergibt sich bei einer Schaltfrequenz von 10 kHz sogar eine Verringerung der Verlustleistung um 55%. Wie ersichtlich sind die Unterschiede der Verluste im Hochlastbereich geringer als im Teillastbereich.

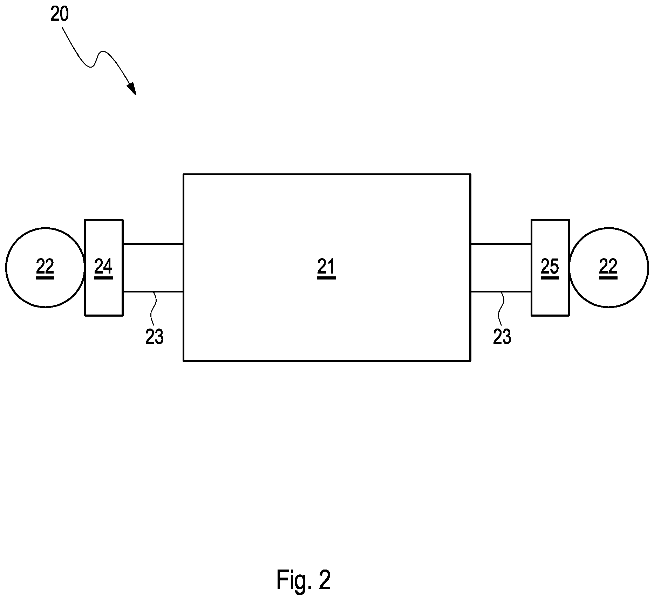

Figur 2 zeigt eine schematische Darstellung eines Antriebssystems 20 mit zwei unterschiedlichen Invertern 24 und 25. Ein Si-Inverter 24 versorgt eine erste E-Maschine 22, ein SiC-Inverter 25 eine zweite E-Maschine 22. Die Beiden Inverter 24 und 25 sind jeweils über DC-HV-Kabel 23 mit einer HV-Batterie 21 verbunden, die den Gleichstrom zum Betrieb der Inverter 24 und 25 bereitstellt. Die mit dem Si-Inverter 24 verbundene erste E-Maschine 22 kann beispielsweise auf der Vorderachse des Kraftfahrzeugs angeordnet sein und diese antreiben, und die mit dem SiC-Inverter 25 verbundene zweite E-Maschine 22 kann auf der Hinterachse des Kraftfahrzeugs angeordnet sein und diese antreiben. Es können selbstverständlich auch mehr als zwei Antriebe in einem Fahrzeug miteinander kombiniert werden.

### Bezugszeichenliste

- 11: Schaltverluste
- 12: Durchlassverluste
- 20: Antriebssystem
- 21: HV-Batterie
- 22: E-Maschine
- 23: DC-HV-Kabel
- 24: Si-Inverter
- 25: SiC-Inverter

## Patentansprüche

1. Elektrisches Antriebssystem (20) für ein Kraftfahrzeug, welches mindestens zwei elektrische Maschinen (22) sowie mindestens einen Inverter (24) mit Silizium-Halbleiterbauteilen und mindestens einen Inverter (25) mit Siliziumkarbid-Halbleiterbauteilen aufweist, **dadurch gekennzeichnet, dass** mindestens eine elektrische Maschine (22) der mindestens zwei elektrischen Maschinen von dem mindestens einen Si-Inverter (24) versorgt wird und für das Antreiben einer Vorderachse des Kraftfahrzeugs eingerichtet ist, und mindestens eine elektrische Maschine (22) der mindestens zwei elektrischen Maschinen von dem mindestens einen SiC-Inverter (25) versorgt wird und für das Antreiben einer Hinterachse des Kraftfahrzeugs eingerichtet ist, wobei im Fahrbetrieb des Kraftfahrzeugs ausschließlich über SiC-Inverter (25) mit Wechselstrom versorgte elektrische Maschinen (22) zum Antreiben einer Hinterachse des Kraftfahrzeugs genutzt werden, wenn eine Momentanforderung kleiner ist als ein maximal von den über SiC-Inverter (25) versorgten elektrischen Maschinen (22) erzeugbares Drehmoment; und sowohl über SiC-Inverter (25) mit Wechselstrom versorgte elektrische Maschinen (22) zum Antreiben einer Hinterachse des Kraftfahrzeugs als auch über Si-Inverter (24) mit Wechselstrom versorgte elektrische Maschinen (22) zum Antreiben einer Vorderachse des Kraftfahrzeugs genutzt werden, wenn die Momentanforderung größer ist als das maximal von den über SiC-Inverter (25) mit Wechselstrom versorgten elektrischen Maschinen (22) erzeugbare Drehmoment.

2. Elektrisches Antriebssystem (20) nach Anspruch 1, worin der Inverter (24) mit Silizium-Halbleiterbauteilen mindestens einen Si-IGBT und mindestens eine Si-Diode umfasst.

3. Elektrisches Antriebssystem (20) nach Anspruch 1 oder 2, worin der Inverter (25) mit Siliziumkarbid-Halbleiterbauteilen mindestens einen SiC-MOSFET umfasst.

4. Elektrisches Antriebssystem (20) nach Anspruch 1 oder 2, worin der Inverter (25) mit Siliziumkarbid-Halbleiterbauteilen mindestens einen Si-IGBT und mindestens eine SiC Diode umfasst.

5. Elektrisches Antriebssystem (20) nach einem der Ansprüche 1 bis 4, bei dem die Inverter (24, 25) Sinuswechselrichter sind.

6. Elektrisches Antriebssystem (20) nach Anspruch 5, worin die Inverter (24, 25) im Zerhackerbetrieb durch Pulsweitenmodulation eine sinusförmige Ausgangsspannung erzeugen.

7. Elektrisches Antriebssystem (20) nach Anspruch 6, worin die Schaltfrequenz der Inverter (24, 25) in einem Bereich von 10 kHz bis 25 kHz liegt.

8. Verfahren zum Betreiben eines elektrischen Antriebssystems (20) gemäß einem der voranstehenden Ansprüche, **dadurch gekennzeichnet, dass** im Fahrbetrieb des Kraftfahrzeugs ausschließlich über SiC-Inverter (25) mit Wechselstrom versorgte elektrische Maschinen (22) zum Antreiben einer Hinterachse des Kraftfahrzeugs genutzt werden, wenn eine Momentanforderung kleiner ist als ein maximal von den über SiC-Inverter (25) versorgten elektrischen Maschinen (22) erzeugbares Drehmoment; und
sowohl über SiC-Inverter (25) mit Wechselstrom versorgte elektrische Maschinen (22) zum Antreiben einer Hinterachse des Kraftfahrzeugs als auch über Si-Inverter (24) mit Wechselstrom versorgte elektrische Maschinen (22) zum Antreiben einer Vorderachse des Kraftfahrzeugs genutzt werden, wenn die Momentanforderung größer ist als das maximal von den über SiC-Inverter (25) mit Wechselstrom versorgten elektrischen Maschinen (22) erzeugbare Drehmoment.

## Claims

1. Electrical drive system (20) for a motor vehicle, which has at least two electric machines (22) as well as at least one inverter (24) with silicon semiconductor components and at least one inverter (25) with silicon carbide semiconductor components, **characterised in that** at least one electric machine (22) of the at least two electric machines are supplied by the at least one Si inverter (24) and is configured to drive a front axle of the motor vehicle, and at least one electric machine (22) of the at least two electric machines is supplied by the at least one SiC inverter (25) and is configured to drive a rear axle of the motor vehicle, wherein in driving mode of the motor vehicle, electric machines (22) supplied with alternating current solely via SiC inverter (25) are used to drive a rear axle of the motor vehicle, when a torque demand is less than a maximum torque that can be produced by the electric machines (22) supplied via SiC inverter (25); and both electric machines (22) supplied with alternating current by SiC inverter (25) are used to drive a rear axle of the motor vehicle and also electric machines (22) supplied with alternating current by Si inverter (24) are used to drive a front axle of the motor vehicle, when the torque demand is greater than the maximum torque that can be produced by the electric machines (22) supplied with alternating current via SiC inverter (25).

2. Electrical drive system (20) according to claim 1, wherein the inverter (24) with silicon semiconductor components comprises at least one Si-IGBT and at least one Si-diode.

3. Electrical drive system (20) according to claim 1 or 2, wherein the inverter (25) with silicon carbide semiconductor components comprises at least one SiC-MOSFET.

4. Electrical drive system (20) according to claim 1 or 2, wherein the inverter (25) with silicon carbide semiconductor components comprises at least one Si-IGBT and at least one SiC diode.

5. Electrical drive system (20) according to any of claims 1 to 4, wherein the inverters (24, 25) are sine wave inverters.

6. Electrical drive system (20) according to claim 5, wherein the inverters (24, 25) generate a sinusoidal output voltage by pulse width modulation in chopper mode.

7. Electrical drive system (20) according to 6, wherein the switching frequency of the inverters (24, 25) is in a range of 10 kHz to 25 kHz.

8. Method for operating an electrical drive system (20) according to any of the preceding claims, **characterised in that** in driving mode of the motor vehicle electric machines (22) supplied with alternating current solely via SiC inverter (25) are used to drive a rear axle of the motor vehicle, when a torque demand is less than a maximum torque that can be produced by the electric machines (22) supplied via SiC inverter (25); and both electric machines (22) supplied with alternating current by SiC inverter (25) are used to drive a rear axle of the motor vehicle and also electric machines (22) supplied with alternating current by Si inverter (24) are used to drive a front axle of the motor vehicle, when the torque demand is greater than the maximum torque that can be produced by the electric machines (22) supplied with alternating current via SiC inverter (25).

## Revendications

1. Système de propulsion (20) électrique pour un véhicule automobile, qui présente au moins deux machines électriques (22) ainsi qu'au moins un inverseur (24) avec des composants de semi-conducteur en silicium et au moins un inverseur (25) avec des composants de semi-conducteur en carbure de silicium, **caractérisé en ce qu'**au moins une machine électrique (22) des au moins deux machines électriques est alimentée par l'au moins un inverseur en Si (24) et est conçue pour l'entraînement d'un essieu avant du véhicule automobile, et au moins une machine électrique (22) des au moins deux machines électriques est alimentée par l'au moins un inverseur en SiC (25) et est conçue pour l'entraînement d'un essieu arrière du véhicule automobile, dans lequel dans le mode de déplacement du véhicule automobile, des machines électriques (22) alimentées en courant alternatif exclusivement par le biais de l'inverseur en SiC (25) sont utilisées pour l'entraînement d'un essieu arrière du véhicule automobile, lorsqu'une exigence de couple est inférieure à un couple pouvant être produit au maximum par les machines électriques (22) alimentées par le biais de l'inverseur en SiC (25); et non seulement des machines électriques (22) alimentées en courant alternatif par le biais de l'inverseur en SiC (25) sont utilisées pour l'entraînement d'un essieu arrière du véhicule automobile mais aussi des machines électriques (22) alimentées en courant alternatif par le biais de l'inverseur de Si (24) sont utilisées pour l'entraînement d'un essieu avant du véhicule automobile lorsque l'exigence de couple est supérieure au couple pouvant être produit au maximum par les machines électriques (22) alimentées en courant alternatif par le biais de l'inverseur en SiC (25).

2. Système de propulsion électrique (20) selon la revendication 1, dans lequel l'inverseur (24) comprend avec des composants de semi-conducteur en silicium au moins un IGBT en Si et au moins une diode en Si.

3. Système de propulsion électrique (20) selon la revendication 1 ou 2, dans lequel l'inverseur (25) comprend avec des composants de semi-conducteur en carbure de silicium au moins un MOSFET en SiC.

4. Système de propulsion électrique (20) selon la revendication 1 ou 2, dans lequel l'inverseur (25) comprend avec des composants de semi-conducteur en carbure de silicium au moins un IGBT en Si et au moins une diode en SiC.

5. Système de propulsion électrique (20) selon l'une quelconque des revendications 1 à 4, pour lequel les inverseurs (24, 25) sont des onduleurs sinusoïdaux.

6. Système de propulsion électrique (20) selon la revendication 5, dans lequel les inverseurs (24, 25) produisent dans le mode de hachage par modulation d'impulsions en largeur une tension de départ sinusoïdale.

7. Système de propulsion électrique (20) selon la revendication 6, dans lequel la fréquence de commutation des inverseurs (24, 25) se situe dans une plage de 10 kHz à 25 kHz.

8. Procédé de fonctionnement d'un système de propulsion (20) électrique selon l'une quelconque des revendications précédentes, **caractérisé en ce que** dans le mode de déplacement du véhicule automobile, des machines électriques (22) alimentées en courant alternatif exclusivement par le biais d'un inverseur en SiC (25) sont utilisées pour l'entraînement d'un essieu arrière du véhicule automobile lorsqu'une exigence de couple est inférieure à un couple pouvant être produit au maximum par les machines électriques (22) alimentées par le biais d'un inverseur en SiC (25) ; et non seulement des machines électriques (22) alimentées en courant alternatif par le biais de l'inverseur en SiC (25) sont utilisées pour l'entraînement d'un essieu arrière du véhicule automobile mais aussi des machines électriques (22) alimentées en courant alternatif par le biais de l'inverseur en Si (24) sont utilisées pour l'entraînement d'un essieu avant du véhicule automobile lorsque l'exigence de couple est supérieure au couple pouvant être produit au maximum par les machines électriques (22) alimentées en courant alternatif par le biais de l'inverseur en SiC (25).
